Europäisches Patentamt

European Patent Office

Office européen des brevets

(19)

(11) Veröffentlichungsnummer: **0 097 261**
**B1**

(12) **EUROPÄISCHE PATENTSCHRIFT**

(45) Veröffentlichungstag der Patentschrift:
16.03.88

(21) Anmeldenummer: 83105220.4

(22) Anmeldetag: 26.05.83

(51) Int. Cl.⁴: **G 06 K 15/12**, H 04 N 1/036,
B 41 J 3/21

(54) Drucker mit einem optischen Druckkopf zum zeilenweisen Aufzeichnen von Graphik- und Textinformationen.

(30) Priorität: 19.06.82 DE 3223031

(43) Veröffentlichungstag der Anmeldung:
04.01.84 Patentblatt 84/1

(45) Bekanntmachung des Hinweises auf die Patenterteilung:
16.03.88 Patentblatt 88/11

(84) Benannte Vertragsstaaten:
CH DE FR GB IT LI SE

(56) Entgegenhaltungen:
EP-A-0 051 896
DE-A-3 031 295
GB-A-2 079 049
US-A-3 850 517

(73) Patentinhaber: OLYMPIA Aktiengesellschaft,
Olympiastrasse, D-2940 Wilhelmshaven (DE)

(72) Erfinder: Behrens, Herbert, Goethestrasse 1,
D-2932 Neuenburg (DE)
Erfinder: Schmitt, Jürgen, Schweier- Aussendeich,
D-2883 Stadland 2 (DE)
Erfinder: Marx, Rainer, Banter Weg 138, D-2940
Wilhelmshaven (DE)
Erfinder: Heidemann, Helmut, Kurze Strasse 19,
D-2940 Wilhelmshaven (DE)
Erfinder: Schipper, Gerhard, Poststrasse 21, D-2981
Rechtsupweg (DE)

EP 0 097 261 B1

LIBER, STOCKHOLM 1988

## Beschreibung

Die Erfindung betrifft einen Drucker mit einem optischen Druckkopf zum zeilenweisen Aufzeichnen von Graphik- und Textinformationen der im Gattungsbegriff der Patentansprüche 1 und 4 angegebenen Art.

In Datenverarbeitungsanlagen werden Schnelldrucker benötigt, um die elektrischen Eingangssignale in eine sichtbare Darstellung umzuformen, die als Ausdruck leicht erkennbar ist. Für diesen Zweck sind auch Drucker mit optischen Druckköpfen mit Erfolg eingesetzt worden. So ist eine optische Schreibeinrichtung mit einem lichtempfindlichen Aufzeichnungsträger, Fotopapier oder Aufzeichnungszwischenträger und einem elektrisch steuerbaren optischen Bauteil mit Bildpunktelementen, die den Lichtfluß sperren oder durchlassen durch die deutsche Offenlegungsschrift 25 57 254 bekannt. Ein optischer Drucker mit einem magnetisch steuerbaren optischen Bauteil ist durch die deutsche Offenlegungsschrift 28 12 206 bekannt. Hierbei wird von einer integrierten Lichtmodulationsmatrix ausgegangen, bei der weder ein abzulenkender Lichtstrahl noch elektrostatische Aufladungen für den eigentlichen Druckvorgang erforderlich sind. Eine derartige integrierte Lichtmodulationsmatrix ist in der deutschen Offenlegungsschrift 26 06 596 beschrieben, die auf der Lichtmodulation durch magnetooptische Speicherschichten, wie z. B. Eisengranatschichten, aufbauen. Diese Schichten bestehen aus einer regelmäßigen Anordnung von Lichtschaltelementen, die über aufgedampfte Leiterbahn- und Widerstandsschichten rein elektronisch geschaltet werden. Bei hoher Integrationsdichte können zeilenförmige Lichtschaltkomponenten mit über tausend Elementen aufgebaut werden. Die Lichtschaltelemente sind zwischen einer ständigen Lichtquelle und einem lichtempfindlichen Aufzeichnungsträger angeordnet und sind durch einen Zeichengenerator derart steuerbar, daß das von der Lichtquelle ständig ausgestrahlte Licht an vorbestimmten Zeichenrasterpunkten bedarfsweise sperr- bzw. durchlaßbar ist. Um eine einzige gerade Bildzeile auf der lichtempfindlichen Oberfläche bilden zu können, sind viele nebeneinander in einer Reihe und quer zur Transportrichtung des Aufzeichnungsträgers angeordnete Lichtschaltelemente erforderlich. Zwischen diesen Lichtschaltelementen und dem Aufzeichnungsträger ist eine Optik zur Anpassung an die Abdruckfläche des Aufzeichnungsträgers angeordnet.

Weiterhin ist durch die deutsche Offenlegungsschrift 30 31 295 ein optischer Drucker bekannt, bei dem die schaltbaren Lichtschaltelemente aus lichtemittierenden Festkörper-Leuchtdioden bestehen. Diese Lichtemissionselemente sind hierbei blockweise zu Lichtemissionsanordnungen zusammengefaßt, die alternierend in zwei parallel zu den Aufzeichnungszeilen angeordneten Reihen vorgesehen sind, wobei jeder Reihe eine eigene Abbildungsoptik-Reihe zugeordnet ist. Die Abbildungsoptik besteht hierbei aus einer Selfoc-Linse. Diese zweireihige Anordnung ist erforderlich, um eine durchgehende Zeile auf dem Aufzeichnungsträger erzeugen zu können, da die Lichtemissionselemente kürzer sind als ihre Trägerkörper und die Abbildungsoptik nur im Verhältnis von 1 : 1 abbilden kann.

Beim Stand der Technik sind übrigens die Lichtemissionselemente als schmale Balken mit den Abmessungen von 90 Mikrometer in der Querrichtung und von 20 Mikrometer in Transportrichtung des Aufzeichnungsträgers ausgeführt, wobei sich bei einer Aufrechterhaltung der Leichtzeit für einen Vorschubweg des Zwischenträgers von z. B. 80 Mikrometer ein belichteter Fleck von 100 Mikrometer ergibt. Dieses bedeutet, daß bei einer relativ hohen Arbeitsgeschwindigkeit eines Druckers von den Lichtemissionselementen eine hohe Arbeitsleistung in Form von Lichtemission aufgebracht werden muß, was insbesondere auch durch die dadurch erhöhten Wärmeabführprobleme zu Einschränkungen in der Lebensdauer führen kann.

Um eine gleichmäßige durchgehende Lichtzeile auf der lichtempfindlichen Oberfläche eines Trägers erzeugen zu können, ist ein gleichmäßiger Abstand der aneinandergereihten Lichtemissionselemente erforderlich. Der für eine hohe Auflösung notwendige geringe Abstand von 10 Mikrometer erfordert eine hohe Fertigungsgenauigkeit, eine schwierige Montage und Justage.

Weiterhin sind durch die US-PS-3 850 517 bereits mehrere unmittelbar nebeneinander angeordnete Lichtemissionselemente bekannt, deren Lichtaustrittsflächen in Transportrichtung des Aufzeichnungsträgers eine mehrfache Länge als in Querrichtung aufweisen. Um mit dieser Anordnung eine gleichmäßige durchgehende Lichtzeile auf der lichtempfindlichen Oberfläche eines Trägers erzeugen zu können, ist ein gleichmäßiger Abstand der aneinander gereihten Lichtemissionselemente erforderlich. Der für eine hohe Auflösung notwendige geringe Abstand von zehn Mikrometern erfordert mit dem Gegenstand der US-PS-3 850 517 eine hohe Fertigungsgenauigkeit, eine schwierige Montage und Justage. Auch ist die Erzeugung einer durchgehenden gleichmäßigen Lichtzeile auf dem Aufzeichnungsträger mit der bekannten Anordnung nur schwer zu erzielen.

Der Erfindung liegt die Aufgabe zugrunde, einen optischen Drucker mit schaltbaren Lichtemissionselementen zu schaffen, der gegenüber dem Stand der Technik einfacher zu fertigen, zu montieren und zu justieren ist. Außerdem soll ein Einsatz von lichtunempfindlicheren Oberflächen (Selen, Silizium gegenüber z. B. Arsen-Selenid) auf den Trägern (Trommel) ermöglicht werden, wodurch der elektrofotografische Prozeß unempfindlicher gegenüber Streulicht sein soll. Weiterhin soll das Lichtangebot derart erhöhbar sein, daß Druckgeschwindigkeiten bis zu 100 Blatt pro Minute erreicht werden können. Diese Aufgabe wird durch die in den Kennzeichen der Patentansprüche 1 und 4 angegebenen Merkmale gelöst.

Durch die Vergrößerung der lichtemittierenden Flächen der einzelnen Lichtemissionselemente wird entweder eine gleiche Lichtausbeute bei auf die Fläche bezogen geringerer Leistungsaufnahme oder eine wesentlich vergrößerte Lichtausbeute bei auf die Fläche bezogen gleicher Leistungsaufnahme bewirkt.

Die vergrößerte Flächenausdehnung der Lichtemissionselemente in Arbeitsrichtung der lichtempfindlichen Oberfläche wird einfach durch Vergrößerung der Lichtaustrittsflächen jedes einzelnen Lichtemissionselementes erzielt.

Bei dem neuen Drucker werden die Fertigung und die Montage sowohl der einzelnen Lichtemissionselemente in den Blöcken der Lichtemissionsanordnungen als auch der Blöcke selbst sehr vereinfacht. Weitere vorteilhafte Ausgestaltungen des Erfindungsgegenstandes sind den weiteren Unteransprüchen zu entnehmen.

Die Erfindung wird anhand der Figuren nachstehend erläutert. Es zeigt:

Figur 1 eine schematische Ansicht eines optischen Druckerks mit dem Erfindungsgegenstand,

Figur 2 eine Einzelheit aus Figur 1 in schaubildlicher Darstellung,

Figur 3 eine erste Ausführungsform von Lichtemissionselementen,

Figur 4 eine weitere Ausführungsform der Lichtemissionselemente und der Lichtemissionsanordnungen,

Figur 5 eine zweite Ausführungsform der Lichtemissionsanordnungen und

Figur 6 eine dritte Ausführungsform der Lichtemissionsanordnungen.

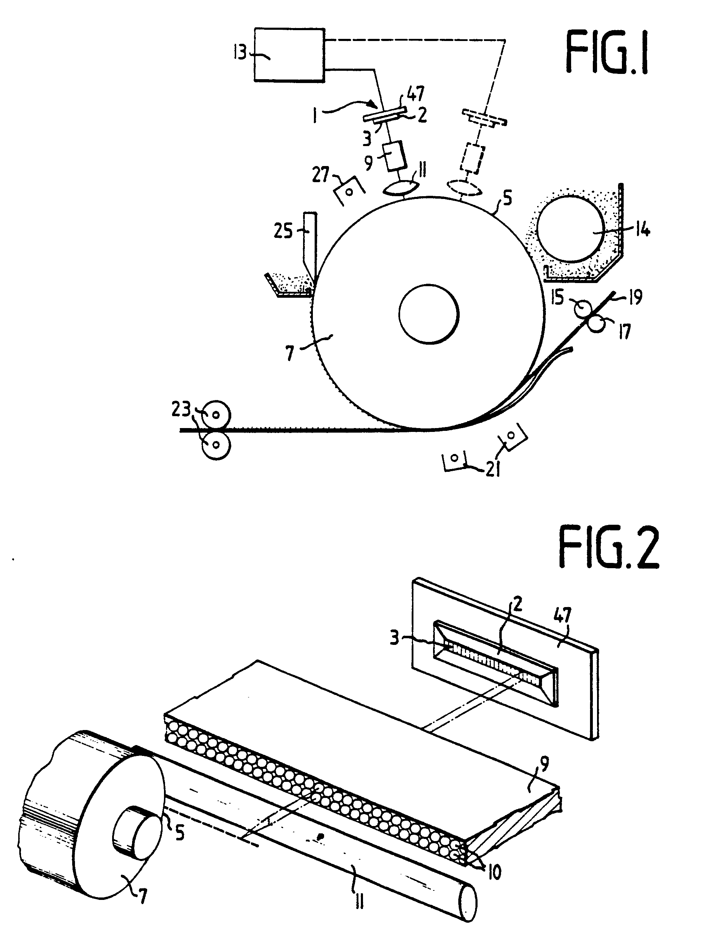

In der Figur 1 ist ein Drucker mit einem optischen Druckkopf 1 zum zeilenweisen Aufzeichnen von Graphik- und Textinformationen gemäß der Erfindung dargestellt. Von einer nicht näher dargestellten Treiberschaltung, die z. B. ein Bestandteil einer Zeichengeneratoranordnung sein kann, werden in bekannter Weise Lichtemissionsanordnungen 2 mit einer Vielzahl von Lichtemissionselementen 3 angesteuert. Die von diesen Lichtemissionselementen 3 der Lichtemissionsanordnungen 2 dargestellten Informationen werden in einer Aufzeichnungszeile auf einer lichtempfindlichen Oberfläche 5 einer als Aufzeichnungsträger dienenden Trommel 7 mittels optischer Abbildungssysteme 9, 11 abgebildet. Die als ansteuerbaren optischen Bauelemente dienenden Lichtemissionselemente 3 können allerdings auch ersetzt werden durch andere Abbildungssysteme, wie z. B. magneto-optische Schaltelemente (nicht dargestellt), mittels denen von einer Lichtquelle ständig ausgestrahltes Licht an vorbestimmten Zeichenrasterpunkten bedarfsweise sperr- bzw. durchlaßbar ist. Das von den Lichtemissionselementen ausgesendete Lichtbild wird über eine als Abbildungsoptik dienende Selfoc-Linse 9 zu einer längs der lichtempfindlichen Oberfläche 5 in Zeilenrichtung angeordneten Zylinderlinse 11 geleitet, durch welche (11) die Abbildungsfläche der einzelnen Lichtemissionselemente 3 auf der lichtempfindlichen Oberfläche 5 in deren Bewegungsrichtung auf eine für eine hohe Auflösung erforderliche Lichtpunktgröße verkleinerbar ist, während die Abbildung in Zeilenrichtung mit dem Verhältnis von 1 : 1 erfolgt, siehe Figur 2. Die Zylinderlinse 11 ist wesentlich, da nur so der Lichtsammlereffekt erreichbar ist. Durch den optischen Druckkopf 1 wird auf diese Weise ein zeilenweises Aufzeichnen von Graphik- und Textinformationen auf dem lichtempfindlichen Aufzeichnungsträger 5 ermöglicht, wobei das so erzeugte latente Bild in bekannter Weise elektrofotografisch entwickelt und fixiert wird. Zu diesem Zweck sind eine Entwicklungsvorrichtung 14, ein Papiereinzugsrollenpaar 15, 17 zum Einziehen eines Aufzeichnungsblates 19, eine Übertragungsstation 21 und eine aus Preßwalzen besteende Fixiervorrichtung 23 vorgesehen. Außerdem sind um die Trommel 7 noch eine Reinigungsvorrichtung 25 und eine Aufladekorona 27 vorgesehen.

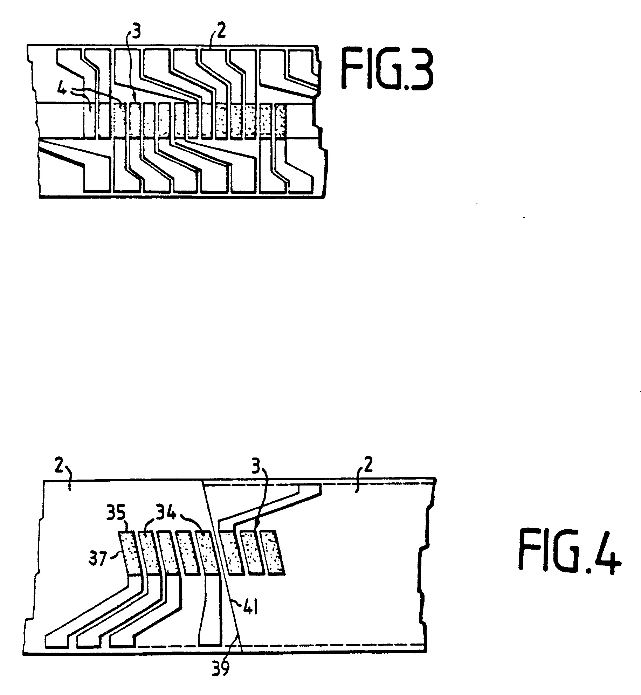

Um eine gleiche Lichtausbeute bei auf die Fläche bezogen geringerer Leistungsaufnahme oder eine wesentlich vergrößerte Lichtausbeute bei auf die Fläche bezogen gleicher Leistungsaufnahme zu bewirken, beträgt die lichtemittierende Fläche 4 der Lichtemissionselemente 3 in Transportrichtung des lichtempfindlichen Trägers 7 ein Mehrfaches der Fläche der auf der lichtempfindlichen Oberfläce 5 zu erzeugender Lichtpunkte. Die von den Lichtemissionselementen 3 ausgesendeten Lichtbilder werden durch die Selfoc-Linsen-Anordnung 9 1 : 1 auf die Zylinderlinse 11 übertragen, wobei die Zylinderlinse 11 die Lichtbilder dann in der einen Richtung verkleinert auf der lichtempfindlichen Oberfläche 5 abbildet. Gemäß Figur 3 weist die lichtemittierende Fläche 4 der Lichtemissionselemente 3 in Transportrichtung der lichtempfindlichen Oberfläche 5 eine mehrfache Länge als die Ausdehnung in Querrichtung auf.

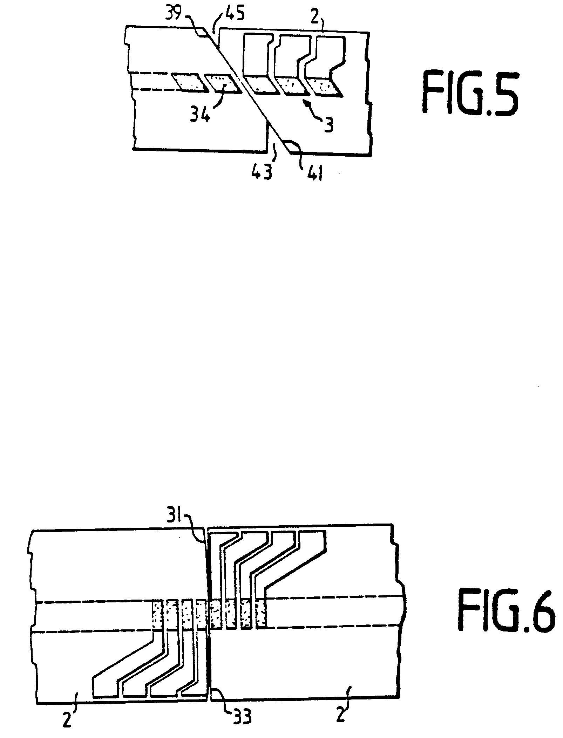

Zur Erzeugung einer gleichmäßigen Lichtzeile auf der lichtempfindlichen Oberfläche 5 ist dann, wenn alle Elemente 3 über die gesamte Zeilenlänge in einer Reihe hintereinander angeordnet sein sollen, erforderlich, daß sowohl die Lichtemissionselemente 3 innerhalb derselben Lichtemissionsanordnung 2 als auch die benachbarten Lichtemissionselemente zweier aneinandergereihter Lichtemissionsanordnungen 2 den gleichen Abstand zueinander aufweisen. Daher müssen die Lichtemissionsanordnungen 2 genau auf Maß auch an den Anlageflächen gefertigt werden. Bereits geringe Verunreinigungen der Anlageflächen der Lichtemissionsanordnungen 2 können zu ungenauen Montagen führen. Dieses wird erfindungsgemäß gemäß Figur 6 dadurch vermieden, daß mindestens eine Anlagefläche 31 der Lichtemissionsanordnungen 2 leicht gerundet ausgebildet ist. Die Gegenanlagefläche 33 kann hierbei eben ausgebildet sein. Durch die leicht abgerundete Anlagefläche 31 ergibt sich eine punktförmige Anlage der zu montierenden Anordnung zueinander, wodurch sich Staubkörnchen etc. bei dem Zusammenfügen der Blöcke zwischen den Anlageflächen 31, 33 nicht so störend auswirken können, siehe Figur 6.

Die Lichtemissionselemente 3 gemäß Figur 3 haben in einer möglichen Ausführungsform eine Breite von 90 Mikrometer und zueinander einen Abstand von 10 Mikrometer, der zur elektrischen Entkoppelung der einzelnen Lichtemissionselemente 3 dient. Dieser ansich geringe Abstand hat theoretisch den Nachteil, daß beim Ausdrucken über einen lichtempfindlichen Zwischenträger (Kopiertrommel), dessen latentes Bild mit einem Toner entwickelt wird, in den durch die fotografisch abgebildeten LED-Lichtpunkte nicht abgedeckten Bereichen Zonen entstehen, die nicht eindeutig löschbar sind. In diesem Grenzbereich könnte dieser Effekt noch entweder mit einer gezielten Unschärfe der abgebildeten LED-Elemente oder durch eine beabsichtigte "Über- bzw. Unterbelichtung", bei der die Ränder der Linien oder Zeichen unscharf sind bzw. verbreitet oder verengt erscheinen, ausgeglichen werden. Da dieser Abstand von 0,01 mm jedoch im Grenzbereich oder noch unterhalb des Auflösungsvermögens des elektrofotografischen Prozesses liegt, wäre ein solcher Aufbau der einzelnen Elemente noch ausreichend sicher in der Funktion. Dieser geringe Abstand von 10 Mikrometer kann aber fertigungstechnisch allerdings dann nicht mehr eingehalten werden, wenn zwei Lichtemissionsanordnungen 2 direkt aneinanderstoßen sollen. Erfahrungsgemäß dürfte sich dieser Abstand dann mindestens verdoppeln, wodurch es dann zu Störungen in einem Druckbild kommen kann. Dieser Nachteil wird durch eine vorteilhafte Weiterbildung des Erfindungsgegenstandes dadurch vermieden, daß die lichtemittierenden Flächen 34 der einzelnen Lichtemissionselemente 3 gemäß Figur 4 parallelogrammartig ausgebildet sind, wobei die kurzen Seiten 35 quer und die langen Seiten 37 schräg zur Transportrichtung der lichtempfindlichen Oberfläche 5 derart verlaufen, daß eine Überlappung in den Übergangsbereichen zwischen den einzelnen Lichtemissionselementen 3 auch beim Übergang zwischen zwei Lichtemissionsanordnungen 2 gegeben ist. Hierdurch bleibt die galvanische Trennung der einzelnen Lichtemissionselemente 3 eindeutig erhalten. Durch die Überlappung in den Übergangsbereichen werden die Anforderungen an die Fertigung, Montage und Justage der einzelnen Lichtemissionselemente 3 sehr herabgesetzt. Diese Vorteile werden bei Paralleldruckern mit mehreren unmittelbar aneinandergereihten Lichtemissionsanordnungen 2 dadurch erreicht, daß die zusammenfügbaren Anlageflächen 39, 41 der einzelnen Blöcke der Lichtemissionsanordnungen 2 parallel zu den langen Seiten 37 der parallelogrammartig ausgebildeten Flächen 34 der Lichtemissionselemente 3 verlaufen, siehe Figur 4. Die Abstandsunterschiede können weiterhin noch dadurch besser eingehalten werden, wenn die Anlageflächen 39, 41 an ihren äußeren Enden je eine Freiarbeitung 43, 45 gemäß Figur 5 aufweisen. Diese Freiarbeitungen 43, 45 entstehen durch Abschneiden der spitzwinkligen Ecken der parallelogrammartig ausgebildeten Blöcke der Lichtemissionsanordnungen 2.

**Patentansprüche**

1. Drucker mit einem optischen Druckkopf (1) zum zeilenweisen Aufzeichnen von Graphik- und Textinformationen, der mehrere Lichtemissionsanordnungen (2) mit je einer Vielzahl von Lichtemissionselementen (3) aufweist, wobei die Lichtemissionselemente selektiv erregbar und in einer Reihe angeordnet sind und lichtemittierende Flächen aufweisen, die in Transportrichtung einer lichtempfindlichen Oberfläche eine Länge haben, die ein mehrfaches der Länge der auf der lichtempfindlichen Oberfläche zu erzeugenden Lichtpunkte ist, und wobei eine optische Vorrichtung (9, 11) mit einer Abbildungsoptik (9) und einer zwischen dieser und der lichtempfindlichen Oberfläche angeordneten Optik (11) vorgesehen ist, durch welche die Abbildungsflächen der einzelnen Lichtemissionselemente auf der lichtempfindlichen Oberfläche eines z. B. als Trommel ausgebildeten Trägers auf die erforderliche Lichtpunktgröße zu einer Zeile zusammenziehbar sind, dadurch gekennzeichnet, daß die Lichtemissionsanordnungen (2) in Blöcken zu einer Reihe aneinander angeordnet sind, und daß die lichtemittierenden Flächen (34) der Lichtemissionselemente (3) parallelogrammartig ausgebildet sind, wobei die kurzen Seiten (35) quer und die langen Seiten (37) schräg zur Transportrichtung der lichtempfindlichen Oberfläche (5) derart verlaufen, daß eine Überlappung sowohl in den Übergangsbereichen zwischen den einzelnen Lichtemissionselementen (3) als auch zwischen den Lichtemissionsanordnungen (2) gegeben ist.

2. Drucker nach Anspruch 1, dadurch gekennzeichnet, daß die zusammenfügbaren Anlageflächen (39, 41) der einzelnen Blöcke der Lichtemissionsanordnungen (2) parallel zu den langen Seiten (37) der parallelogrammartig ausgebildeten Flächen (34) der Lichtemissionselemente (3) verlaufen.

3. Drücker nach Anspruch 1, dadurch gekennzeichnet, daß die Anlageflächen (39, 41) an ihren äußeren Enden eine Freiarbeitung (43, 45) aufweisen.

4. Drucker mit einem optischen Druckkopf (1) zum zeilenweisen Aufzeichnen von Graphik- und Textinformationen, der mehrere Lichtemissionsanordnungen (2) mit je einer Vielzahl von Lichtemissionselementen (3) aufweist, wobei die Lichtemissionselemente selektiv erregbar und in einer Reihe angeordnet sind und lichtemittierende Flächen aufweisen, die in Transportrichtung einer lichtempfindlichen Oberfläche eine Länge haben, die ein mehrfaches der Länge der auf der lichtempfindlichen Oberfläche zu erzeugenden Lichtpunkte ist, und wobei eine optische Vorrichtung (9, 11) mit einer Abbildungsoptik (9) und einer zwischen dieser und der lichtempfindlichen Oberfläche angeordneten Optik (11) vorgesehen ist, durch welche die Abbildungsflächen der einzelnen Lichtemissionselemente auf der lichtempfindlichen Oberfläche eines z. B. als Trommel ausgebildeten Trägers auf die erforderliche Lichtpunktgröße zu einer Zeile zusammenziehbar sind, dadurch gekennzeichnet, daß die Lichtemissionsanordnungen (2) in Blöcken zu einer Reihe aneinander angeordnet sind und und daß mindestens eine Anlagefläche (31) der Lichtemissionsanordnungen (2) abgerundet ist.

## Revendications

1. Imprimante comportant une tête d'impression optique (1) destinée au tracé ligne par ligne d'informations graphiques et textuelles, qui présente plusieurs ensembles (2) d'émission de lumière comportant chacun une pluralité d'éléments (3) d'émission de lumière, lesdits éléments (3) pouvant être excités sélectivement, étant disposés en une rangée, et présentant des surfaces émettrices de lumière qui, dans la direction de déplacement d'une surface photosensible, ont une longueur multiple de la longueur des points lumineux à produire sur la surface photosensible, comprenant en outre, un dispositif (9, 11) optique comportant une optique (9) de reproduction et une optique (11) disposée entre cette dernière et la surface photosensible, grâce à laquelle les surfaces de reproduction des éléments d'émission de lumière individuels peuvent être assemblés pour former une ligne sur la surface photosensible d'un support ayant notamment la forme d'un tambour, avec la grosseur de points lumineux nécessaire, imprimante caractérisée par le fait que les ensembles (2) émetteurs de lumière sont disposés les uns à côté des autres sous forme de blocs en une rangée et que les surfaces émettrices (34) de lumière des éléments (3) ont une forme de parallélogramme, les petits côtés (35) étant disposés transversalement à la direction de déplacement de la surface (5) photosensible et les grands côtés (37) obliquement par rapport à cette direction, de telle manière qu'un chevauchement est obtenu aussi bien dans les zones de passage entre les éléments (3) d'émission de lumière qu'entre les ensembles (2) émetteurs de lumière.

2. Imprimante selon la revendication 1, caractérisée par le fait que les surfaces d'appui (39, 41) assemblables entre elles des blocs individuels des ensembles (2) émetteurs de lumière sont disposées parallèlement aux grands côtés des surfaces (34) des éléments (3) en forme de parallélogramme.

3. Imprimante selon la revendication 1, caractérisée par le fait que les surfaces d'appui (39, 41) présentent à leurs extrémités externes une partie abattue (43, 45).

4. Imprimante comportant une tête d'impression optique (1) destinée au tracé ligne par ligne d'informations graphiques et textuelles, présentant plusieurs ensembles (2) émetteurs de lumière comportant une pluralité d'éléments (3) d'émission de lumière pouvant être excités sélectivement et étant disposés en une rangée, comprenant des surfaces émettrices de lumière qui ont, dans la direction de déplacement d'une surface photosensible, une longueur multiple de la longueur des points lumineux à créer sur la surface photosensible, et un système optique (9, 11) comportant une optique de reproduction (9) et une optique (11) disposée entre cette dernière et la surface photosensible, grâce à laquelle les surfaces de reproduction des éléments d'émission de lumière individuels peuvent être assemblés en formant une ligne sur la surface photosensible d'un support ayant notamment la forme d'un tambour, avec la grosseur de points lumineux nécessaire, caractérisée par le fait que les ensembles (2) émetteurs de lumière sont disposés les une à côté des autres sous forme de blocs en uns rangée et qu'au moins une des surfaces d'appui (31) des ensembles (2) émetteurs de lumière est arrondie.

## Claims

1. A printer having an optical print head (1) for the line by-line recording of graphic and text information, which comprises a plurality of light-emission arrangements (2) each with a plurality of light-emission elements (3), wherein the light-emission elements can be excited selectively and are arranged in a row and comprise light-emitting faces which, in the conveying direction of a photosensitive surface, have a length which is a multiple of the length of the light spots to be produced on the photosensitive surface and wherein an optical device (9, 11) is provided, having an image-forming optical system (9) and an optical system (11) which is disposed between the latter and the photosensitive surface and through which the imaging areas of the individual light-emission elements on the photosensitive surface of a support constructed for example in the form of a drum can be contracted to the necessary size of light spot to form a line, characterised in that the light-emission arrangements (2) are positioned adjacent to one another in blocks to form a row and that the light emitting faces (34) of the light-emission elements (3) are of parallelgram-like construction, the short sides (35) extending transversely and the long sides (37) extending obliquely to the conveying direction of the photosensitive surface (5), in such a manner that there is over lapping both in the transition regions between the individual light-emission elements (3) and between the light-emission arrangements (2).

2. A printer according to Claim 1, characterised in that the contact surfaces (39, 41), which can be joined together, of the individual blocks of the light-emission arrangements (2) extend parallel to the long sides (37) of the parallelgram-like faces (34) of the light-emission elements (3).

3. A printer according to Claim 1, characterised in that the contact surfaces (39, 41) comprise a relief (43, 45) at their outer ends.

4. A printer having an optical print head (1) for the line-by-line recording of graphic and text information, which comprises a plurality of light-emission arrangements (2) each with a plurality of light-emission elements (3), wherein the light-emission elements can be excited selectively and are arranged in a row and comprise light-emitting faces which, in the conveying direction of a photosensitive surface, have a length which is a multiple of the length of the light spots to be produced on the photosensitive surface and wherein an optical device (9, 11) is provided having an image-forming optical system (9) and an optical system (11) which is disposed between the latter and the photosensitive surface and by means of which the imaging areas of the individual light-emission elements on the photosensitive surface of a support constructed for example in the form of a drum can be contracted to the necessary size of light spot to form a line, characterised in that the light-emission arrangements (2) are arranged adjacent to one another in blocks to form a row and that at least one contact surface (31) of the light-emission arrangements (2) is rounded.

FIG.1

FIG.2

FIG.3

FIG.4

FIG.5

FIG.6